# EUROPÄISCHE PATENTANMELDUNG

(11) **EP 0 854 662 A2**
(43) Veröffentlichungstag der Anmeldung: **22.07.1998**
(21) Anmeldenummer: 97890254.2
(22) Anmeldetag: 18.12.1997
(51) Int. Cl.: H05B 33/10

(54) **Elektrolumineszenz-Farbbildschirm**

(30) Priorität: 18.12.1996 US 768495
(71) Anmelder: Leising, Günther, Prof. Dipl.-Ing Dr., 8042 Graz (AT); Hage GmbH & Co. KG, 8472 Obdach (AT)
(72) Erfinder: Leising, Günther, Dr., 8042 Graz (AT); Hampel, Stefan, 8742 Obdach (AT); Meghdadi, Farideh, Dipl.-Ing., 8010 Graz (AT); Tasch, Stefan, Dipl.-Ing., 8380 Jennersdorf (AT)
(74) Vertreter: Gibler, Ferdinand, Dipl.Ing. Dr. techn.

(57) **Zusammenfassung**

Elektrolumineszenz-Farbbildschirm mit Matrixbildpunkten, bestehend aus einem Schichtsystem von übereinander und teilweise nebeneinander aufgetragenen Einzelschichten, welche eine isolierende, optisch zumindest transluzente Grundschicht, eine leitfähige, optisch zumindest transluzente Grundelektrode, eine strukturierte elektrisch isolierende Zwischenschicht, eine organische Elektrolumineszenzschicht, eine Deckelektrodenschicht, gegebenenfalls eine oder mehrere matrixartig aufgetragene Farbwandlerschichten und gegebenenfalls eine oder mehrere Indexanpassungsschichten umfaßt, wobei die Grundelektrode durchgehend flächig auf der Grundschicht aufgetragen ist, die isolierende Zwischenschicht aus der organischen Elektrolumineszenzschicht gebildete, matrixartig angeordnete Bildpunktflächen gitterartig umschließt und über diese vorsteht, und die auf jede Bildpunktfläche aufgetragene Deckelektrode sich über die benachbarte Gitterwand teilweise erstreckt.

## Beschreibung

Die Erfindung betrifft einen Elektrolumineszenz-Farbbildschirm mit Matrixbildpunkten, bestehend aus einem Schichtsystem von übereinander und teilweise nebeneinander aufgetragenen Einzelschichten, welches eine isolierende, optisch zumindest transluzente Grundschicht, eine leitfähige, optisch zumindest transluzente Grundelektrodenschicht, eine strukturierte elektrisch isolierende Zwischenschicht, eine organische Elektrolumineszenzschicht, eine Deckelektrodenschicht, gegebenenfalls eine oder mehrere matrixartig aufgetragene Farbwandlerschichten und gegebenenfalls eine oder mehrere Indexanpassungsschichten umfaßt.

Bekannte Farbbildschirme dieser Art sind aufgrund der steigenden Nachfrage nach kleinen und handlichen Anzeigebildschirmen ins Zentrum vielseitiger technologischen Anstrengungen gerückt, sind aber bei der Herstellung und beim Betreiben mit verschiedenen Nachteilen behaftet.

So sind etwa die Umrandungen der einzelnen Bildpunkte aufgrund des Herstellungsverfahrens nicht klar definiert und in ihrer Formgebung nur begrenzt veränderbar. Weiters sind durch die streifenartige Anordnung der Grundelektrode die Bildpunkte eines jedes Streifens aufgrund des relativ hohen Zuleitungswiderstandes nur in einem begrenzten Ausmaß gleichzeitig ansteuerbar und die realisierbaren Bidschirmgrößen begrenzt.

Aufgabe der Erfindung ist es daher, einen Farbbildschirm mit scharf abgegrenzten Bildpunktflächen anzugeben, bei dem keine Beschränkung hinsichtlich der Ansteuerung bestimmter Punkte der Bildpunktmatrix herrscht und der in nahezu beliebiger Größe realisiert werden kann.

Eine weitere Aufgabe der Erfindung ist es, eine kleinere Bildpunktfläche zu realisieren und die aktive optische Schicht gegen Umwelteinflüsse zu schützen.

Erfindungsgemäß wird dies dadurch erreicht, daß die Grundelektrodenschicht durchgehend flächig auf der Grundschicht aufgetragen ist, daß die isolierende Zwischenschicht gitterartig aufgetragen ist und aus der organischen Elektrolumineszenzschicht gebildete, matrixartig angeordnete Bildpunktflächen randseitig umschließt und über diese vorsteht, und daß die auf jede Bildpunktfläche aufgetragene Deckelektrode sich teilweise über die sie umrandende Gitterwand erstreckt.

Durch eine solche gitterartige Umrandung der einzelnen Bildpunkte ist zum einen eine klare Abgrenzung ihrer Form gegeben, wodurch die Bildschärfe bedeutend gesteigert werden kann. Weiters ist dadurch auch die Gestaltung von vielen möglichen Bildpunktformen etwa in kreisförmiger oder sechseckiger Form möglich. Es gelingt durch den erfindungsgemäßen Aufbau auch eine einfachere und flexiblere Ansteuerung der Bildpunkte zu erreichen, da durch die sonst üblichen Elektrodenstreifen mit ihrem relativ großen Innenwiderstand die Anzahl der gleichzeitig ansteuerbaren Bildpunkte bisher begrenzt möglich war. Eine Kurzschlußbildung im Bereich dieser Elektrodenstreifen kann ebenso verhindert werden.

In weiterer Ausbildung der Erfindung kann vorgesehen sein, daß zwischen der Elektrolumineszenzschicht und der Deckelektrodenschicht eine weitere, sich jeweils über die gesamte Bildpunktfläche erstreckende Deckelektrodenschicht aufgetragen ist.

Diese weitere Deckelektrodenschicht schließt die empfindliche Elektrolumineszenzschicht hermetisch ab, sodaß keine schädlichen Umwelteinflüsse wirksam werden können.

In weiterer Ausbildung der Erfindung kann vorgesehen sein, daß eine oder mehrere spektral selektive Spiegel- bzw. Transmissionsschichten zur spektralen Reinigung des in den Farbwandlerschichten erzeugten Lichtes angeordnet sind.

Dadurch kann die Farbreinheit der Farbbildpunkte und damit die farbgetreue Anzeige des Farbbildschirmes verbessert werden.

Gemäß einer anderen Variante der Erfindung kann vorgesehen sein, daß die Grundschicht aus einzelnen, in Emissionsrichtung des Lichtes angeordneten Lichtleitern zusammengesetzt ist.

Eine solche Grundschicht ergibt eine sehr hohe Transmission des erzeugten Lichtes und ist unempfindlich gegen die beim Herstellungsvorgang eines erfindungsgemäßen Farbbildschirmes verwendeten Ätz- und Lösungsmittel.

Weiters kann zwischen der oder den Farbwandlerschicht(en) und der Grundelektrodenschicht eine Passivierungsschicht aufgetragen sein.

Die Passivierungsschicht schafft einen optisch neutralen Dickenausgleich der verschiedenen verwendeten Schichtanordnungen.

In weiterer Ausbildung der Erfindung können die aus fluoreszierenden Farbstoffen gebildeten Farbwandlerschichten chemisch als Seitenketten an ein Trägerpolymer gebunden sein. Farbstoffe dieser Art bieten eine besonders hohe Farbumwandlungsrate.

Gemäß einer anderen Variante der Erfindung kann vorgesehen sein, daß die Moleküle der fluoreszierenden Farbstoffe der Farbwandlerschichten in diese matrixartig und voneinander isoliert eingebaut sind.

Farbstoffe dieser Art bieten eine besonders hohe Farbumwandlungsrate.

Besonders bevorzugt kann die organische Elektrolumineszenzschicht aus blau emittierendem Poly- oder Oligophenylen gebildet sein, da die mit diesem Material erreichte Leuchtstärke im blauen Spektrum und der damit erzielte, optische Wirkungsgrad besonders hoch ist.

Für die Herstellung eines erfindungsgemäßen Farbbildschirmes hat es sich als besonders vorteilhaft herausgestellt, wenn die elektrisch isolierende Zwischenschicht aus Photoresist-Lack gebildet ist, da auf diese Weise sehr kleine Strukturen in die Zwischenschicht geätzt werden können.

Weiters kann die organische Elektrolumineszenzschicht aus zwei oder drei verschiedenen elektrolumineszierenden Materialien gebildet sein, wobei besonders bevorzugt die verschiedenen elektrolumineszierenden Materialien aus rot emittierenden Eu-Komplexen, aus grün emittierenden Ga-Komplexen und aus blau emittierendem Poly- oder Oligophenylen gebildet sein können, welche Materialien eine besonders hohe Leuchtstärke in ihrem Wellenlängenbereich erzeugen können.

Es können weiters die Gitterzellen der Zwischenschicht rechteckförmig sein, sodaß die üblichen Anforderungen an eine Bildpunktfläche für einen Farbbildschirm erfüllt sind. Alternativ dazu können aber auch ganz andere geometrische Formen mit Hilfe der Gittereinrahmung durch die Zwischenschicht ermöglicht werden.

Weitere Aufgabe der Erfindung ist es, ein Verfahren zur Herstellung eines Elektrolumineszenz-Farbbildschirmes anzugeben, das eine technisch einfache Realisierung eines erfindungsgemäßen Farbbildschirmes ermöglicht.

Dies wird erfindungsgemäß dadurch erreicht. daß die Grundelektrodenschicht durchgehend flächig auf die Grundschicht aufgetragen wird. daß die elektrisch isolierende Zwischenschicht auf die Grundelektrodenschicht gitterartig aufgetragen wird, sodaß innerhalb jeder Gitterzelle des Zwischenschichtgitters die Grundelektrodenschicht in der Größe einer Bildpunktfläche bestehen bleibt, daß auf die Bildpunktflächen die Elektrolumineszenzschicht aufgetragen wird, wobei die Gitterzellenwände über die Elektrolumineszenzschicht vorstehen und diese jeweils randseitig umschließen, daß darauffolgend mittels Teilchenstrom, z.B. durch Aufdampfen, in Richtung der Oberflächennormale der Elektrolumineszenzsschicht die weitere Deckelektrodenschicht durchgehend flächig und danach mittels Teilchenstrom, z.B. durch Aufdampfen, in einer gegen die Normale vcrkippten Richtung die Deckelektrodenschicht aufgetragen wird, welche sich jeweils über die Elektrolumineszenzschicht und teilweise über die jeweilige Gitterwand bis zu deren Stirnseite erstreckt, sodaß eine von den Nachbargitterzellen isolierte Kontaktierung der Elektrolumineszenzschicht gebildet wird.

Auf diese Weise können sehr genau definierte Gitterzellen mit darin befindlichen Elektrodenlumineszenzschichten hergestellt werden, wobei die Grundelektrode nicht wie bisher üblich in Form mehrerer paralleler Streifen sondern durchgehend flächig gestaltet ist, sodaß sich der Zuleitungswiderstand zu den einzelnen Bildpunkten entsprechend erniedrigt. Das sonst durch die Elektrodenstreifen begrenzte gleichzeitige Anschalten mehrerer Bildpunkte kann damit ohne Probleme durchgeführt werden. Durch das erfindungsgemäße Verfahren läßt sich auch eine wesentliche Erniedrigung der kleinstmöglichen Bildpunktfläche erzielen, da aufgrund der Gitterstruktur eine klare Abgrenzung derselben möglich ist. Durch die weitere Deckelektrodenschicht kann die Elektrolumineszenzschicht in der Gitterzelle eingekapselt werden, sodaß keine schädlichen Umwelteinflüsse auf diese wirken können.

Nachfolgend wird die Erfindung anhand der beigeschlossenen Zeichnungen eingehend erläutert. Es zeigt dabei:
Fig.1 einen Grundriß eines erfindungsgemäßen Farbildschirmes;
Fig.2 einen teilweisen Schnitt durch den Farbbildschirm gemäß Fig.1;
Fig.3 einen Schnitt durch die Darstellung in Fig.2;
Fig.4 den schematischen Aufbau einer organischen Elektrolumineszenz-Diode und
Fig.5 die Struktur blau emittierender organischer Stoffe.

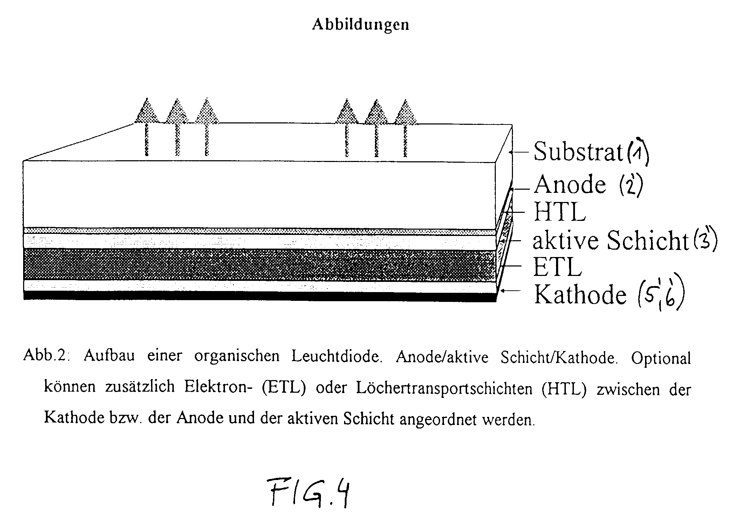

In Fig.2 ist ein Elektrolumineszenz-Farbbildschirm mit Matrixbildpunkten dargestellt, der aus einem Schichtsystem von übereinander und teilweise nebeneinander aufgetragenen Einzelschichten besteht. Eine isolierende, optisch zumindest transluzente Grundschicht 1 bildet den Grundkörper für den Farbbildschirm. Auf dieser ist eine leitfähige, optisch transparente, zumindest transluzente Grundelektrodenschicht 2 angeordnet, auf welche eine strukturierte elektrisch isolierende Zwischenschicht 4 folgt. Jeweils zwischen dieser ist eine organische Elektrolumineszenzschicht 3 aufgetragen, auf der wiederum jeweils zwei Deckelektrodenschichten 5, 6 angeordnet sind.

Auf der gegenüberliegenden Seite der Grundschicht 1 finden sich verschiedene fluoreszierenden Farbwandlerschichten 7, die eine Farbumwandlung der in der Elektrolumineszenzschicht 3 bewirkten Strahlung ermöglichen. An manchen Bildpunkten fehlt diese Farbwandlerschicht 7 und läßt die erzeugte Grundstrahlung durch, während an anderen Stellen wiederum eine Anordnung von zwei oder mehreren Farbwandlerschichten 7 vorgenommen worden ist. Eine Schutzschicht 9 ist auf die Grundschicht 1 folgend oder auf den Farbwandlerschichten 7 aufgebracht. Danach folgt zum Dickenausgleich eine Passivierungsschicht 8, auf der wiederum teilweise spektral selektive Spiegel- bzw. Transmissionsschichten 10 zur spektralen Reinigung des in den Farbwandlerschichten erzeugten Lichtes angeordnet sind.

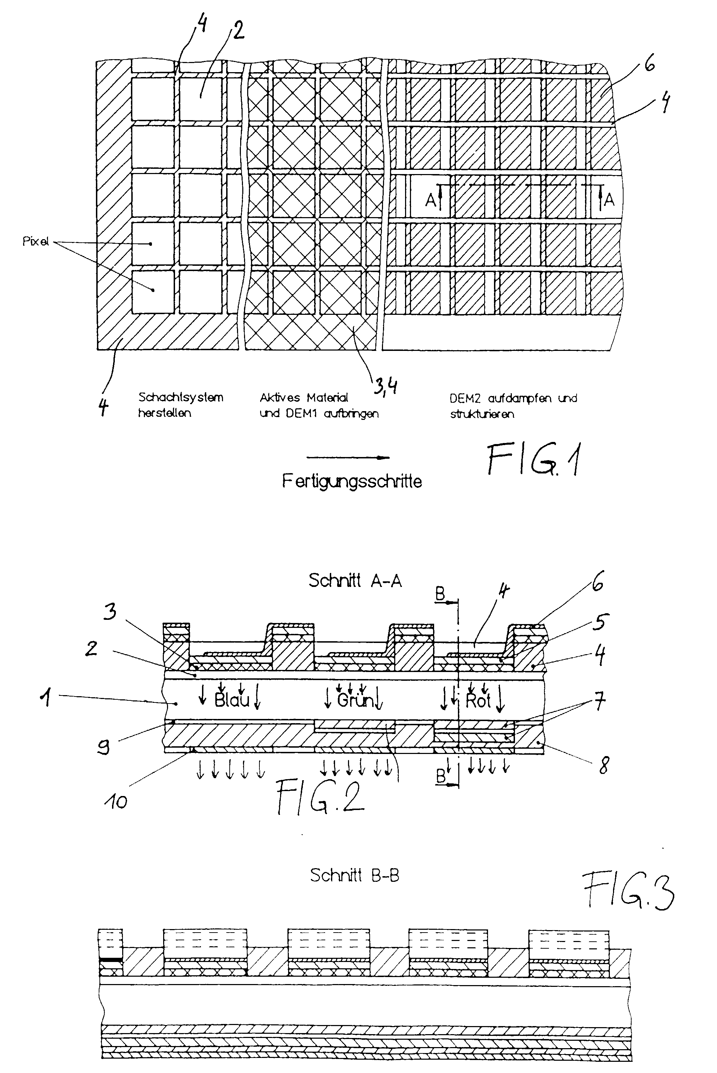

Um eine genau definierte Bildpunktfläche zu erzielen, ist nun erfindungsgemäß die Grundelektrodenschicht 2 durchgehend flächig auf der Grundschicht 1 und die isolierende Zwischenschicht 4 gitterartig aufgetragen, wie aus Fig.1 zu ersehen ist. Dadurch umschließt die gitterartige Zwischenschicht die aus der das Licht erzeugenden organischen Elektrolumineszenzschicht 3 gebildeten, matrixartig angeordneten Bildpunktflächen jeweils randseitig, steht dabei aber über diese vor.

Die auf die Bildpunktfläche aufgetragene Deckelektrodenschicht 6 erstreckt sich teilweise über die sie umrandende Gitterwand des Zwischenwandgitters 4 bis zu deren Stirnfläche. Wie aus Fig.1 ersichtlich, ist die Anordnung dieser Deckelektrodenschicht 6 so gewählt, daß sie zwar eine Verbindung zur Elektrolumineszenzschicht 3 herstellt, jedoch zu den umgebenden Gitterzellen isoliert ist.

Zwischen der Elektrolumineszenzschicht 3 und der Deckelektrodenschicht 6 befindet sich eine weitere Deckelektrodenschicht 5, die die Elektrolumineszenzschicht 3 hermetisch abschließt und gegen Umwelteinflüsse schützt.

Bevor eine weitere Erläuterung des erfindungsgemäßen Aufbaus vorgenommen wird, soll kurz auf das der Erfindung zugrundeliegende Prinzip der Elektrolumineszenz mit Bezugnahme auf Fig.4 näher eingegangen werden.

Eine organische Leuchtdiode besteht grundsätzlich aus einer organischen Schicht 3', die zwischen zwei Elektroden 2', 5',6' angeordnet ist. Durch Anlegen einer Spannung an diese Elektroden 5', 6'werden Elektronen von der Kathode 5', 6'und Löcher von der Anode 2' in die aktive organische Schicht 3' injiziert. Die ungleichnamigen Ladungsträger triften unter dem angelegten elektrischen Feld in unterschiedliche Richtungen und können daher in der Schicht miteinander wechselwirken, um angeregte Zustände zu bilden. Die angeregten Zustände können strahlend in den Grundzustand zurückkehren und dadurch das Elektrolumineszenzlicht erzeugen. Um dies effizient zu vollziehen, ist es nötig, daß die Austrittsarbeiten der beiden Elektroden einerseits gut mit der Valenzbandoberkante und andererseits gut mit der Leitfähigkeitsunterkante der aktiven Schicht übereinstimmen.

Um eine möglichst gute Elektroneninjektion von der Kathode zu gewährleisten. soll das Kathodenmaterial gute Leitfähigkeit und eine an das aktive Medium angepaßte und daher möglichst geringe Austrittsarbeit (<4 - 4,5 eV) besitzen. Da besonders Materialien mit geringen Austrittsarbeiten üblicherweise sehr reaktiv sind, z.B. Alkali- und Erdalkalimetalle, ist zusätzlich eine möglichst hohe Umgebungsstabilität des Kathodenmaterials gefordert. Einige Materialien, die als Kathodenmaterial verwendet werden können, sind z.B. Al, Ag, Mg, Ca, In und Legierungen zwischen diesen Materialien.

Um eine möglichst gute Löcherinjektion von der Anode zu gewährleisten, soll das Anodenmaterial gute Leitfähigkeit und eine möglichst hohe Austrittsarbeit (>4 - 4,5 eV) besitzen. Einige Materialien, die als Anodenmaterial verwendet werden können, sind z.B. Au, Pt, Cu. Des weiteren können durch Dotierung entarteter Halbleiter, wie z. Indium-Zinn-Oxide (ITO), dotierte Zinkoxide, Indiumoxide und andere dotierte Halbleiter mit großer Energielücke, und dotierte Filme konjugierter Polymere, z.B. dotiertes Polyanilin, verwendet werden. Die letztgenannten Materialien besitzen im Vergleich zu den Metallelektroden den Vorteil, daß sie hohe Transparenz im sichtbaren Spektralbereich aufweisen. Dies ist insofern von Bedeutung, weil das im aktiven Medium der Leuchtdiode generierte Licht, durch die Elektroden des Bauelements emittiert wird und die Verluste dabei möglichst gering sein sollen. Aus diesem Grund muß (zumindest) eine der beiden Elektroden transparent oder zumindest semitransparent ausgeführt werden. Üblicherweise wird die Anode daher transparent oder semitransparent ausgeführt, es kann aber auch die Kathode semitransparent gemacht werden.

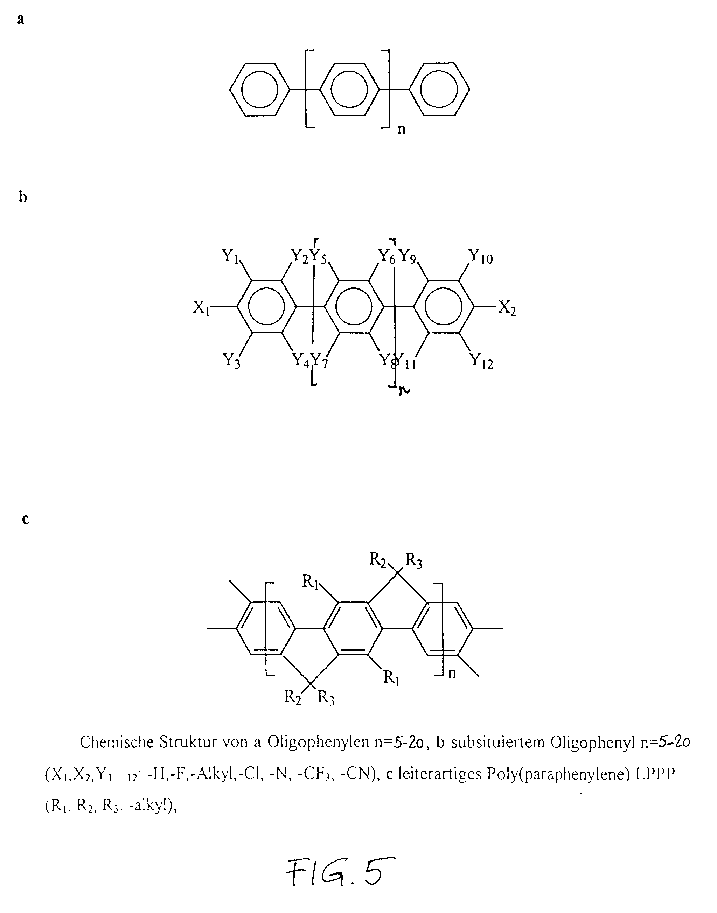

Im einfachsten Fall besteht die Elektrolumineszenzschicht aus einer organischen lichtemittierenden Schicht. Diese Schicht soll gute Ladungstransporteigenschaften, hohe Photolumineszenz- Quantenausbeute und eine geringe Defektkonzentration besitzen. Blau emittierende Leuchtdioden sind von besonderem Interesse, da das blaue Licht zur Anregung von Farbstoffschichten verwendet werden kann, wodurch das blaue Licht in grünes und rotes Licht umwandelbar ist. Organische Materialien, die chemisch dem Oligo- oder Polyphenylen ähnlich sind, haben sich als besonders geeignet für die Anwendung in blauen LED herausgestellt (Fig.5).

Durch die Anwendung von in Fig.4 dargestellten, zusätzlichen Ladungstransportschichten zwischen der aktiven Schicht und den Elektroden können die Bauelemente entscheidend verbessert werden. Eine Ursache dafür ist, daß durch die Zwischenschichten die angeregten Zustände von den Elektroden isoliert werden, so daß das Löschen der Lumineszenz an Defektzuständen, die bevorzugt in der Nähe der Elektroden anzufinden sind, reduziert wird. Des weiteren kann durch Einsetzen spezieller Ladungstransportschichten die Effizienz und die Lebensdauer der Bauelemente weiter verbessert werden:
Eine Ladungstransportschicht, die zwischen der aktiven Schicht und Kathode angeordnet ist und hohe Elektronen- und nur eingeschränkte Löcherbeweglichkeit besitzt, wird als Elektrontransportschicht (ETL) bezeichnet. Die Elektroneneninjektion in die aktive Schicht kann durch eine ETL-Schicht entscheidend verbessert werden, wenn sich das LUMO-CB (niedrigster unbesetzter Molekülzustand) der ETL-Schicht energetisch unterhalb des Leitfähigkeitsbandes der aktiven Schicht aber über der Fermikante der Kathode befindet. Durch die ETL kann also die Elektroneninjektion kontrolliert werden, so daß die Anzahl der injizierten Elektronen der Anzahl der injizierten Löcher angeglichen werden kann, wodurch die Effizienz des Bauelementes dadurch entscheidend verbessert wird. Die Effizienz der Baulemente kann weiters dadurch verbessert werden, wenn sich das HOMO-V-B (höchstes besetztes Molekülniveau) des ETL energetisch unterhalb des Valenzbandes der aktiven Schicht befindet. In diesem Falle werden Elektronen und Löcher an der Grenzfläche ETL/aktive Schicht lokalisiert und können daher besser miteinander wechselwirken und angeregte Zustände werden effizienter ausgebildet.

Eine Ladungstransportschicht, die zwischen der aktiven Schicht und der Anode angeordnet ist und hohe Löcher- und nur eingeschränkte Elektronenbeweglichkeit besitzt, wird als Löchertransportschicht (HTL) bezeichnet. Die Löcherinjektion in die aktive Schicht kann durch die HTL-Schicht entscheidend verbessert werden, wenn sich das HOMO-VB der HTL energetisch unterhalb der Fermikante der Anode aber oberhalb des Valenzbandes der aktiven Schicht befindet. Dadurch kann eine Absenkung der Operationsfeldstärke erzielt werden und die Lebensdauer der Bauelemente dadurch erhöht werden.

Aus blauem Licht können alle anderen Farben erhalten werden, da die blaue Farbe die höchstenergetische aller Spektralfarben darstellt. Beleuchtet man einen Farbstoff, der grün emittiert, mit blauem Licht, so wird der grüne Farbstoff durch das blaue Licht angeregt und emittiert nachfolgend grünes Licht. Das Licht wird also von einer Farbe, die energetisch höher liegt, in eine Farbe die energetisch tiefer liegt umgewandelt - dieser Prozeß ist das Grundprinzip der Photolumineszenz.

Dieser Effekt kann auch ausgenutzt werden, um das Licht einer blau emittierenden organischen Leuchtdiode in andere Farben umzuwandeln. Bedeckt man nämlich die blaue Diode mit einer oder mehreren verschiedenen Farbstoffschicht(en), so kann man alle sichtbaren Farben inklusive weiß und infrarot herstellen.

Bedeckt man eine blaue Parahexaphenyl (PHP)- Leuchtdiode mit einer Schicht eines Coumarin 102 Farbstoffes in einer Polymetacrylat (PMMA)-Matrix wird das blaue Licht der PHP-Diode in grünes Emissionslicht umgewandelt. Es wird dabei grünes Licht erzeugt, das dreimal so hell für das menschliche Auge wie das anregende blaue Licht erscheint, da das menschliche Auge im grünen Spektralbereich sehr viel empfindlicher ist. Die Quantenkonversionsausbeute von blau auf grün beträgt in diesem Fall ungefähr 40%. Wird die Farbstoffschicht direkt auf das Elektrolumineszenz-Bauelement ohne einer Luftschicht dazwischen aufgebracht, kann die Quantenkonversionsausbeute bis auf 90 % erhöht werden, da dadurch Wellenleitungeffekte zwischen den Schichten minimiert werden. Die Erzeugung roter Emissionsfarben mittels blauem Licht ist schwieriger, da die meisten Farbstoffe, die im Roten emittieren, nur geringe Absorption im Blauen zeigen und daher mit blauem Licht nicht effizient angeregt werden können. Aus diesem Grund kann man einen roten Farbstoff mit einem grünen koppeln und die Farbkonversion von blau → grün → rot erzielen.

Bedeckt man die PHP-Diode z.B. mit einer Coumarin 102/P Schicht und anschließend mit einer Schicht eines Farbstoffes Lumogen F300 in PMMA, so erhält man rotes Licht. In diesem Fall beträgt die Quantenkonversionsausbeute Blau → Rot etwa 10%, wenn man die Schichten ohne Brechzahlanpassung übereinander anordnet, bzw. 40 % wenn die Schichten direkt aufeinander aufgebracht werden (ohne Luftschicht dazwischen).

Die Grundfarben Rot-Grün-Blau eines Farbbildschirmes müssen spektral sehr rein sein, um eine vollständige Farbmischung zu ermöglichen. Da die spektrale Emissionsverteilung organischer Moleküle und Molekülverbindungen oft sehr breit ist, müssen die Emissionsfarben zumeist noch speziell nachbehandelt werden, um die Bedingung der spektralen Reinheit zu erfüllen. Bei der oben beschriebenen Farbkonversionstechnik ist eine spektrale Reinigung vor allem dann unumgänglich, wenn das Emissionslicht der Farbstoffschicht durch einen Anteil verbreitert ist der nicht in der Farbstoffschicht absorbiert wird.

Um das Licht spektral zu reinigen, kann ein Absorptionsfilter verwendet werden, der alle Anteile mit Ausnahme der gewünschten Emissionswellenlängen absorbiert. Der Nachteil dieser Methode ist, daß die Lichtenergie, die außerhalb des gewünschten Wellenlängenbereiches in Wärmeenergie im Absorptionsfilter umgewandelt wird. Die Methode, die im folgenden angewendet wird, um die Emissionsfarben nachträglich spektral zu reinigen, basiert auf einem nicht absorbierenden dielektrischen Bandpaß-Spiegel/Transmitter. Dieser dielektrische Spiegel/Transmitter besteht aus mehreren Schichten von Materialien mit abwechselnd hohem und niedrigem Brechungsindex (z. B. Ti02 (Brechungsindex n = 2. 1) und MgF₂ (n= 1.3)). Der Spiegel/Transmitter besitzt hohe Transmission im gewünschten Emissionsbereich (T>80%) und hohe Reflexion im restlichen sichtbaren Spektralbereich (R>85%). Dadurch kann nur Licht in dem Spektralbereich, in dem der Spiegel/Transmitter hochtransparent ist, den Filter passieren, während das restliche Licht wieder zurückreflektiert wird. Der hochenergetische Anteil des reflektierten Lichtes wird daher zwischen dem spektral selektiven Spiegel/Transmitter und der Grundelektrode so lange hin und her reflektiert, bis es von den Farbstoffschichten absorbiert und umgewandelt wird. Mittels der spektral selektiver Spiegel/Transmitter kann daher eine spektrale Reinigung mit minimalem Energieverlust erzielt werden.

Als Farbwandler werden organische Farbstoffe mit hoher Photolumineszenzquantenausbeute (PLQA) verwendet. Um homogene Schichten herstellen zu können, werden die Farbstoffe in Polymermatrizen (z.B. PMMA, Polystyrol ... ) eingebettet. Wie vorstehend ausgeführt, müssen die Farbwandlerschichten von hoher optischer Dichte sein, damit das Anregungslicht in der Schicht vollständig absorbiert wird. Die optische Dichte der Farbwandlerschicht steigt mit der Konzentration des Farbstoffes in der Polymermatrix. Mit steigender Konzentration des Farbstoffes in Polymermatrizen steigt allerdings auch die Wahrscheinlichkeit zur Ausbildung von Farbstoffaggregaten, wodurch die PLQA der Farbstoffe drastisch abgesenkt wird. Dieser Konzentrationseffekt kann vermieden werden und die nötige optische Dichte trotzdem erzielt werden, wenn die Dicke der Farbwandlerfilme dementsprechend erhöht wird. Beim Aufbau des Bildschirmes muß jedoch berücksichtigt werden, daß sich dicke Farbwandlerschichten negativ auf das Auflösungsvermögen auswirken. Eine weitere Möglichkeit besteht darin, die Aggregatbildung zu minimieren ohne dabei die Schichtdicke der Farbwandlerschichten zu erhöhen. Dies kann einerseits dadurch erreicht werden, indem man die Farbstoffmoleküle als Seitenketten an das Polymer bindet. Mit diesen Seitenkettenpolymeren kann man sehr dünne Filme mit hoher optischen Dichte und hoher PLQA realisieren. Eine andere Möglichkeit die Aggregatbildung zu minimieren besteht darin, die Farbstoffe in einer speziellen kristallinen (z.B. lyotropen) Matrix anzuordnen, worin die Farbstoffmoleküle voneinander isoliert vorliegen. In Matrizen, in der sich die Farbstoffmoleküle in senkrechten zylindrischen Strukturen, die in der Matrix eingebettet sind, anordnen, ist die Emission stärker gerichtet als in einer isotropen Polymermatrix, sodaß in solchen Matrizen das Auflösungsvermögen erhöht wird.

Ein Verfahren zur Herstellung eines erfindungsgemäßen Farbbildschirmes wird anhand der Fig.1 und 2 näher beschrieben.

Die Grundelektrodenschicht 2 wird zunächst durchgehend flächig auf die Grundschicht 1 aufgetragen. Bevorzugt wird dieser Vorgang durch das Aufdampfen der optisch zumindest transluzenten, leitfähigen Grundelektrodenschicht 2 vorgenommen. Die Anforderungen an die dazu verwendbaren Materialien sind:
1) Optische Transparenz von nahezu 100 %
2) Relativ gute Leitfähigkeit ( kleiner spezifischer Widerstand)
3) Passende Austrittsarbeit
4) Widerstandsfähigkeit gegen thermische und mechanische Belastung

Diese Voraussetzungen werden durch das bevorzugt eingesetzte Material Indiumoxid In₂0₃ erfüllt. Die Grundelektrodenschicht 2 wird als kontinuierliche, homogene Schicht flächig auf die Grundschicht 1 aufgedampft und am Rand kontaktiert. Die Schichtdicke kann in einem bevorzugten Bereich bis zu 1 µm betragen.

Auf die Grundelektrode 2 wird die elektrisch isolierende Zwischenschicht 4 gitterartig aufgetragen, wobei die in Fig. 1 erkennbare rechteckförmige Struktur auch andere geometrische Formen. wie kreis- oder sechseckförmig, annehmen kann. Innerhalb jeder Gitterzelle des Zwischenschichtgitters 4 bleibt die Grundelektrodenschicht 2 in der Größe einer Bildpunktfläche bestehen. Als Material für das Zwischenschichtgitter kann ein Photoresist-Lack verwendet werden, der vorzugsweise bis zu 20µm dick über der Grundelektrode aufgebracht wird und mit Hilfe photolithographischer Verfahren gitterartig strukturiert wird, wobei das Belichten auf verschiedene Art und Weise erfolgen kann. Holographische Gitter werden auf ähnliche Art und Weise erzeugt. Anstelle des Photoresist-Lackes kann auch jedes beliebige andere Dielektrikum als Zwischenschicht verwendet werden.

Die den Bildpunktflächen entsprechenden, belichteten Stellen werden weggeätzt und es verbleibt somit ein gitterartiges System von Wänden ( bis zu 20 µm hoch ) und mit einem Boden aus gegen das Ätzmittel beständiger Grundelektrode 2.

Danach wird die optisch aktive Elektrolumineszenzschicht 3 aufgetragen, die aus einem einzelnen oder aus einer Kombination von verschiedenen elektrolumineszierenden Stoffen bestehen kann.

In Abhängigkeit vom verwendeten aktiven Material erfolgt das Aufbringen entweder durch Aufdampfen oder durch sogenanntes "Spincoating", wobei die Schichtdicke des gesamten aktiven Paketes in einer bevorzugten Ausführungsform der Erfindung bis zu 1 µm beträgt. Durch das Aufbringen der Elektrolumineszenzschicht 3 auf die gitterartige Zwischenschichtstruktur 4, wird diese in Form von rechteckigen Bildpunkten strukturiert, wobei die Gitterzellenwände 4 über die Elektrolumineszenzschicht 3 vorstehen und diese jeweils randseitig umschließen.

Nun wird eine Deckelektrodenschicht 5 auf die gesamte Anordnung in Richtung der Normalen zur Elektrolumineszenzschicht 3 - also unverkippt - aufgetragen, welcher Vorgang vorzugsweise durch einen Aufdampfprozeß durchgeführt wird. Beim Aufdampfvorgang wird die Elektrodenschicht im Vakuum durch den beim Verdampfen eines Substrats entstehenden Teilchenstrom aufgebracht, es kann dies aber auch mittels verwandter Techniken, z.B. Sputtern, Ionenimplantation o.ä. geschehen.

Die für eine Deckelektrodenschicht verwendbaren Materialien werden neben einer guten Leitfähigkeit und einer guten Austrittsarbeit noch durch ihr Reflexionsvermögen festgelegt. Es können verschiedene Materialien und Materialkombinationen eingesetzt werden, wobei Schichtdicken bis zu 1 µm Verwendung finden.

Bevorzugt findet ein leitfähiges Material mit niederer Austrittsarbeit, zum Beispiel Al , oder Ca Anwendung, welches gleichmäßig über die Elektrolumineszenzschicht gedampft wird und diese somit vollständig bedeckt.

Darauffolgend wird vorzugsweise durch ein in einer gegen die Grundschichtnormale geneigten Richtung vorgenommenes Aufdampfen, Sputtern, lonenimplantieren o.ä., eine Deckelektrodenschicht 6 aufgetragen, welche sich jeweils über die Elektrolumineszenzschicht und teilweise über die jeweilige Gitterwand bis zu deren Stirnseite erstreckt, sodaß eine von den Nachbargitterzellen isolierte Kontaktierung der Elektrolumineszenzschicht gebildet wird.

Ein geeignetes Material für diese Deckelelektrodenschicht 6 besteht aus einem leitfähigen, harten und kratzfesten Metall, das beispielsweise aufgesputtert werden kann. Es können aber sowohl die Deckelektrodenschicht 6 als auch die weitere Deckelektrodenschicht 5 aus demselben Material gebildet sein.

Zur Anbringung der Deckelektrodenschicht 6 wird der Bildschirmgrundkörper in einem bestimmten Winkel zur Verdampfungsquelle gekippt und das Deckelektrodenmaterial aufgedampft. Durch dieses Verkippen erreicht man an definierter Stelle eine Verbindung zwischen der Deckelektrodenschicht 6 und der Elektrolumineszenzschicht 3, die innerhalb der gitterartigen Struktur angebracht ist, wobei die Deckelektrodenschicht 5 zwischengeschaltet ist.

Zur elektrischen Trennung der einzelnen Gitterzellen wird auf die aufgedampfte Deckelektrodenschicht 6 ein Photoresist-Lack aufgebracht und mittels einer passenden Maske entlang eines Teils der Gitterwände 4 senkrecht zu den kontaktierten Gitterwänden belichtet. Die belichteten Stellen der Gitterwände werden mit den darunterliegenden beiden Deckelektrodenschichten 5,6 und der ebenfalls an diesen Stellen befindlichen Elektrolumineszenzschicht 3 weggeätzt und der verbliebene Photoresist-Lack abgewaschen.

Als Ergebnis erhält man eine schachbrettartige Verteilung von Bildpunkten, von denen alle mit aus den verbleibenden Deckelektrodenschichten 6 gebildeten Kontaktierungsstellen an den dafür vorgesehenen Gitterwänden versehen sind.

Auf der dem Zwischenschichtgitter abgewandten Seite der Grundschicht 1, durch welche das in der Elektrolumineszenzschicht 3 jeder Gitterzelle erzeugte Licht hindurchstrahlt, wird eine Aufbereitung des erzeugten Lichtes für den Farbildschirm vorgenommen. So werden bei Verwendung nur eines Elektrolumineszenzmaterials verschiedene Farbwandlerschichten 7 angebracht, um jeweils Einheiten aus Bildpunkten mit den drei Grundfarben Blau, Grün und Rot (Fig.2) zu bilden, mit denen bekanntermaßen alle anderen Farben erzeugt werden können.

Die als Farbwandlerschichten in Frage kommenden Materialien müssen die eintretende monochrome Strahlung in einem definierten Wellenlängenbereich absorbieren und in einem geeigneten Wellenlängenbereich emittieren und eine hohe Fluoreszenzquantenausbeute erreichen (> 90 % in verdünnten Lösungen), wobei Einzelschichten und Sandwichanordnungen zur Amwendung kommen können.

Zum Aufbringen der die Primärfarben realisierenden Schichten werden folgende Möglichkeiten eingesetzt:

Die im blauen Spektralbereich absorbierende und im grünen emittierende Fluoreszenzschicht 7 wird entweder flächig auf die Grundschicht 1 aufgebracht und anschließend derart strukturiert, daß nur die Bildpunkte freibleiben, die blau leuchten sollen, oder bereits gleich entsprechend strukturiert aufgetragen.

Als nächstes wird über dieser strukturierte Fläche die hochtransparente Schutzschicht 9 aufgebracht und eine weitere im grünen absorbierende und im roten emittierende Fluoreszenzschicht 7 strukturiert. Mit dem Aufbringen der Passivierungsschicht 8 wird eine ebene Oberfläche erreicht und die Fluoreszenzschichten 7 werden durch diese thermisch isoliert. Abschließend werden über alle lichtemittierenden Bildpunkte den drei Primärfarben angepaßte spektral selektive Spiegel/Transmitterschichten 10 strukturiert, die das austretende Licht spektral reinigen.

Der spektral selektive Spiegel/Transmitter 10 kann auch auf die Oberseite einer hochtransparenten Folie strukturiert werden. Auf die Unterseite wird dann wie oben beschrieben das Fluoreszenzpaket bestehend aus Fluoreszenzschichten und hochtransparenter Schutzschicht aufgebracht.

Als vorteilhaft hat sich auch eine Kombinationen aus den beiden vorstehend genannten Verfahren erwiesen, ein Beispiel:

Der spektral selektive Spiegel/Transmitter wird auf die Oberseite einer hochtransparenten Folie strukturiert. Auf die Unterseite wird die im grünen absorbierende und im roten emittierende Fluoreszenzschicht aufgebracht. Auf der Grundschicht 1 wird die im blauen absorbierende und im grünen emittierende Fluoreszenzschicht hergestellt, die hochtransparente Schutzschicht kann optional eingefügt werden.

Die Kontaktstellen des Bildschirmes sind die mit der Deckelektrode 6 beschichteten Gitterwände. Eine Leiterplatine wird in der Form dieser Kontaktstellen strukturiert, entsprechend über dem Bildschirm positioniert und mit der Grundschicht mechanisch verbunden. Da die Deckelektrodenschicht 6 aus einem sehr harten Material besteht, ist die Gefahr einer Zerstörung durch Zerkratzen der Deckelektrode 6 sehr gering. Die beim Verbinden mit der Grundschicht 1 auftretende mechanische Belastung wird voll von den stabilen Gitterwänden 4 aufgenommen , so daß von dieser Seite keine Beeinträchtigung der Elektrolumineszenzschicht 3 zu erwarten ist.

Die Zuführungen an die Leiterplatine werden an ihrer Rückseite befestigt. Die Anzahl der Kontakte ist größer als bei der bekannten X-Y Ansteuerung für eine Bildmatrix, dafür sind sie völlig unabhängig voneinander.

Als Materialien für die Elektrolumineszenzschicht 3 werden Stoffe verwendet, die in der Lage sind, in einer der drei Grundfarben Rot, Grün, Blau zu emittieren. Zum Erreichen einer grünen Emission können beispielsweise Ga-Metallkomplexe, zum Erreichen einer roten Emission Eu-Metallkomplexe verwendt werden.

Wie vorstehend beschrieben, kann die Elektrolumineszenzschicht 3 auch aus einer Kombination von mehreren verschiedenen Materialien bestehen, wobei jedes der drei aktiven Stoffe strukturiert aufgebracht werden muß. Das Strukturieren der Deckelektrode und die Kontaktierung erfolgen ebenso wie vorstehend beschrieben, Farbwandlerschichten sind jedoch nicht notwendig. Optional kann ein spektral selektiver Spiegel/Transmitter entsprechend strukturiert aufgebracht werden. Dies kann sowohl auf der Seite des Gitters als auch der zum Gitter abgewandten Seite erfolgen. Zwischen dem selektiven Spiegel/Transmitter und der optisch transluzenten Elektrodenschicht ist dann wieder eine Passivierungschicht vorgesehen.

## Patentansprüche

1. Elektrolumineszenz-Farbbildschirm mit Matrixbildpunkten, bestehend aus einem Schichtsystem von übereinander und teilweise nebeneinander aufgetragenen Einzelschichten, welches eine isolierende, optisch zumindest transluzente Grundschicht, eine leitfähige, optisch zumindest transluzente Grundelektrodenschicht, eine strukturierte elektrisch isolierende Zwischenschicht, eine organische Elektrolumineszenzschicht, eine Deckelektrodenschicht, gegebenenfalls eine oder mehrere matrixartig aufgetragene Farbwandlerschichten und gegebenenfalls eine oder mehrere Indexanpassungsschichten umfaßt, **dadurch gekennzeichnet**, daß die Grundelektrodenschicht (2) durchgehend flächig auf der Grundschicht (1) aufgetragen ist, daß die isolierende Zwischenschicht (4) gitterartig aufgetragen ist und aus der organischen Elektrolumineszenzschicht (3) gebildete, matrixartig angeordnete Bildpunktflächen randseitig umschließt und über diese vorsteht, und daß die auf jede Bildpunktfläche aufgetragene Deckelektrode (6) sich teilweise über die sie umrandende Gitterwand erstreckt.

2. Farbbildschirm nach Anspruch 1, **dadurch gekennzeichnet**, daß zwischen der Elektrolumineszenzschicht (3) und der Deckelektrodenschicht (6) eine weitere Deckelektrodenschicht (5) aufgetragen ist.

3. Farbbildschirm nach Anspruch 1 oder 2, **dadurch gekennzeichnet**, daß eine oder mehrere spektral selektive Spiegel- bzw. Transmissionsschichten (10) zur spektralen Reinigung des in den Farbwandlerschichten (7) erzeugten Lichtes angeordnet sind.

4. Farbbildschirm nach Anspruch 1, 2 oder 3, **dadurch gekennzeichnet**, daß die Grundschicht aus einzelnen. in Emissionsrichtung des Lichtes angeordneten Lichtleitern zusammengesetzt ist.

5. Farbbildschirm nach einem der vorhergehenden Ansprüche, **dadurch gekennzeichnet**, daß zwischen der oder den Farbwandlerschicht(en) und der Grundelektrodenschicht eine Passivierungsschicht (8) aufgetragen ist.

6. Farbbildschirm nach einem der vorhergehenden Ansprüche, **dadurch gekennzeichnet**, daß die aus fluoreszierenden Farbstoffen gebildeten Farbwandlerschichten chemisch als Seitenketten an ein Trägerpolymer gebunden sind.

7. Farbbildschirm nach einem der Ansprüche 1 bis 5, **dadurch gekennzeichnet,** daß die Moleküle der fluoreszierenden Farbstoffe der Farbwandlerschichten in diese matrixartig und voneinander isoliert eingebaut sind.

8. Farbbildschirm nach einem der vorhergehenden Ansprüche, **dadurch gekennzeichnet**, daß die organische Elektrolumineszenzschicht aus blau emittierenden Poly- oder Oligophenylen gebildet ist.

9. Farbbildschirm nach einem der vorhergehenden Ansprüche, **dadurch gekennzeichnet**, daß die elektrisch isolierende Zwischenschicht aus Photoresist-Lack gebildet ist.

10. Farbbildschirm nach einem der vorhergehenden Ansprüche, **dadurch gekennzeichnet**, daß die organische Elektrolumineszenzschicht aus zwei oder drei verschiedenen elektrolumineszierenden Materialien gebildet ist.

11. Farbbildschirm nach Anspruch 10, **dadurch gekennzeichnet**, daß die verschiedenen elektrolumineszierenden Materialien aus rot emittierenden Eu-Komplexen, aus grün emittiernden Ga-Komplexen und aus blau emittierenden Poly- oder Oligophenylen gebildet sind.

12. Farbbildschirm nach einem der vorhergehenden Ansprüche, **dadurch gekennzeichnet**, daß die Gitterzellen der Zwischenschicht rechteckförmig sind.

13. Verfahren zur Herstellung eines Elektrolumineszenz-Farbbildschirmes nach einem der Ansprüche 1 bis 12, **dadurch gekennzeichnet**, daß die Grundelektrodenschicht (2) durchgehend flächig auf die Grundschicht (1) aufgetragen wird, daß die elektrisch isolierende Zwischenschicht (4) auf die Grundelektrodenschicht (2) gitterartig aufgetragen wird, sodaß innerhalb jeder Gitterzelle des Zwischenschichtgitters die Grundelektrodenschicht (2) in der Größe einer Bildpunktfläche bestehen bleibt, daß auf die Bildpunktflächen die Elektrolumineszenzschicht (3) aufgetragen wird, wobei die Gitterzellenwände über die Elektrolumineszenzschicht (3) vorstehen und diese jeweils randseitig umschließen, daß darauffolgend mittels Teilchenstrom, z.B. durch Aufdampfen, in Richtung der Oberflächennormale der Elektrolumineszenzsschicht (3) die weitere Deckelektrodenschicht (5) durchgehend flächig und danach mittels Teilchenstrom. z.B. durch Aufdamfen, in einer gegen die Normale verkippten Richtung die Deckelektrodenschicht (6) aufgetragen wird, welche sich jeweils über die Elektrolumineszenzschicht (3) und teilweise über die jeweilige Gitterwand (4) bis zu deren Stirnseite erstreckt, sodaß eine von den Nachbargitterzellen isolierte Kontaktierung der Elektrolumineszenzschicht gebildet wird.
